# EUROPEAN PATENT SPECIFICATION

(11) **EP 4 072 009 B1**
(45) Date of publication and mention of the grant of the patent: **14.05.2025**
(21) Application number: 21214935.5
(22) Date of filing: 15.12.2021
(51) Int. Cl.: H02M 3/158, H03F 3/19, H03F 1/02, H03F 3/21, H03F 3/24, H02M 1/00

(54) **SYMBOL-POWER-TRACKING SUPPLY, AND WIRELESS DEVICE USING AMPLIFICATION SYSTEM POWERED BY THE SYMBOL-POWER-TRACKING SUPPLY**
SYMBOL-LEISTUNGSVERFOLGUNGSVERSORGUNG UND DRAHTLOSE VORRICHTUNG MIT EINEM DURCH DIE SYMBOL-LEISTUNGSVERFOLGUNGSVERSORGUNG GESPEISTEN VERSTÄRKERSYSTEM
SUIVI DE PUISSANCE DE SYMBOLES, ET DISPOSITIF SANS FIL À L'AIDE D'UN SYSTÈME D'AMPLIFICATION ALIMENTÉ PAR UN ALIMENTATION DE SUIVI DE PUISSANCE DE SYMBOLES

(30) Priority: 06.04.2021 US 202163171123 P; 01.11.2021 US 202117515925
(43) Date of publication of application: 12.10.2022
(73) Proprietor: MediaTek Inc., Hsinchu City 30078 (TW)
(72) Inventor: HSU, Kuo-Chun, Hsinchu City (TW); LIANG, Chin-Hsiang, Hsinchu City (TW); LIOU, Yan-Ting, Hsinchu City (TW)
(74) Representative: Wright, Howard Hugh Burnby

(56) References cited:
- EP-A1- 3 565 115
- WO-A1-2020/206246
- CN-A- 103 513 684
- US-A1- 2010 007 536
- US-A1- 2017 250 693
- US-A1- 2019 334 480
- US-A1- 2019 386 565
- US-A1- 2021 099 137
- PAEK JI-SEON ET AL: "15.2 A 90ns/V Fast-Transition Symbol-Power-Tracking Buck Converter for 5G mm-Wave Phased-Array Transceiver", 2019 IEEE INTERNATIONAL SOLID- STATE CIRCUITS CONFERENCE - (ISSCC), IEEE, 17 February 2019 (2019-02-17), pages 240 - 242, XP033527913, DOI: 10.1109/ISSCC.2019.8662420

## Description

### Field of the Invention

The present invention relates to a symbol power tracking (SPT) amplification design in a wireless device.

### Description of the Related Art

A wireless device usually requires a radio-frequency power amplifier (RF PA) that converts low-power radio signals to higher power signals to drive an antenna of a transmitter. The supply voltage VPA of the RF PA typically is modulated for symbol power tracking (SPT).

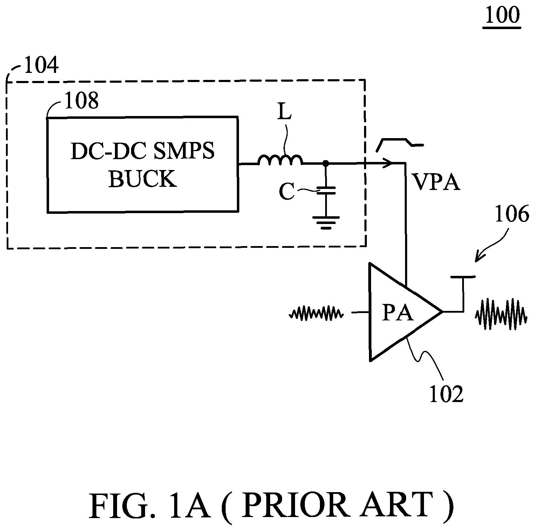

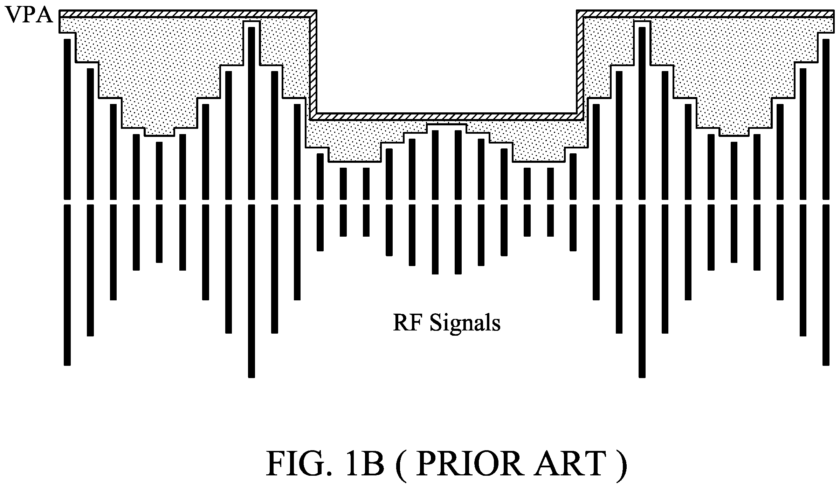

FIG. 1A depicts a conventional SPT amplification design in a wireless device 100. A power amplifier 102 and a dc-dc converter 104 form an SPT amplification system to drive an antenna 106 of a transmitter of the wireless device 100. The dc-dc converter 104 uses a dc-dc switch mode power supply (SMPS) buck 108, an inductor L, and a capacitor C to generate an adaptive supply voltage VPA (i.e., an SPT supply voltage) that tracks the power of the radio frequency (RF) signals to be transmitted by the antenna 106. FIG. 1B shows the SPT supply voltage VPA and the RF signals. As shown, power consumption can be greatly reduced by the SPT supply voltage VPA.

However, the conventional SPT amplification design may result in some problems in high-speed applications (e.g., 5G communication applications). The capacitor C used to regulate the SPT supply voltage VPA typically is huge, e.g., up to several µF. It takes a long time to charge or discharge such a large capacitor C for SPT. In 5G communication applications, however, the cyclic prefix section (CP, prior to each symbol section) for VPA transition is short, e.g., 0.29 µs. The large current to charge/discharge the large capacitor C during such a short transition period (short CP) will result in considerable power loss Patent documents EP3565115A1 (SAMSUNG ELECTRONICS CO LTD [KR]) 6 November 2019 (2019-11-06) and WO2020/206246A1 (APPLE INC [US]) 8 October 2020 (2020-10-08) disclose relevant symbol power tracking supply modulators of the prior art.

### BRIEF SUMMARY OF THE INVENTION

A fast tracking and low loss symbol-power-tracking (SPT) supply that powers a radio-frequency power amplifier (RF PA) (or any electronic element) is shown.

An SPT supply in accordance with an exemplary embodiment of the present invention has a power converter, a transition capacitor, an assisted charging and discharging circuit, and a multi-level array. The power converter is coupled to an output port of an input power source for power conversion, and has an output terminal coupled to a power terminal of the RFPA. The transition capacitor is coupled to the power terminal of the radio-frequency power amplifier though the output terminal of the power converter. The assisted charging and discharging circuit may be coupled to the transition capacitor during cyclic prefix (CP) sections. The multi-level array includes a plurality of voltage-regulated capacitors which are pre-charged to and kept at different voltage levels. During each symbol section, a target capacitor at a fixed voltage level matching the current SPT situation may be selected from among the voltage-regulated capacitors to be coupled to the power terminal of the radio-frequency power amplifier. Each voltage-regulated capacitor is kept at a fixed voltage level. The different voltage levels provided by the different voltage-regulated capacitors match the different SPT supply levels. Rather than periodically charge/discharge a large capacitor, the supply voltage for the RF PA is easily changed to meet the dynamically changed SPT situation by switching the connections between the voltage-regulated capacitors and the power terminal of the radio-frequency power amplifier.

According to the invention as claimed in claim 1, the voltage-regulated capacitors are pre-charged to the different voltage levels during a power-on period. The different voltage-regulated capacitors relate to the different thresholds. When a voltage-regulated capacitor whose voltage level decreases to lower than its corresponding threshold is disconnected from the power terminal of the radio-frequency power amplifier, the voltage-regulated capacitor can be charged to compensate for current leakage.

According to the invention as claimed in claim 1, the voltage-regulated capacitors are pre-charged to the different voltage levels during a power-on period.

Preferably, the different voltage-regulated capacitors corresponding to different thresholds; and when a voltage-regulated capacitor whose voltage level decreases to lower than its corresponding threshold is disconnected from the power terminal of the electronic element, the voltage-regulated capacitor is charged to compensate for current leakage.

Preferably, each voltage-regulated capacitor is more than an order of magnitude larger in size than the transition capacitor.

Preferably, the assisted charging and discharging circuit is coupled to the transition capacitor during cyclic prefix sections; and during each symbol section, the target capacitor and the transition capacitor are connected in parallel.

Preferably, the multi-level array further comprises voltage regulation switches that correspond one-to-one with the voltage-regulated capacitors, and each voltage regulation switch is coupled between the corresponding voltage-regulated capacitor and the power terminal of the electronic element; all voltage regulation switches are open during cyclic prefix sections; the assisted charging and discharging circuit is coupled to the transition capacitor during the cyclic prefix sections; and when a voltage-regulated capacitor is selected as the target capacitor during each symbol section, the corresponding voltage regulation switch is closed to couple the target capacitor to the power terminal of the electronic element.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1A depicts a conventional SPT amplification design in a wireless device 100;
FIG. 1B shows the SPT supply voltage VPA and the RF signals;
FIG. 2 illustrates a wireless device 200 in accordance with an exemplary embodiment of the preset invention;
FIG. 3A depicts the details of a power converter 302, an assisted charging and discharging circuit 304, and a multi-level array 306 in accordance with an exemplary embodiment of the present invention;
FIG. 3B depicts the waveforms of the voltage levels of the voltage-regulated capacitors C1~C4, the battery power VBAT, and the enable signal EN indicating the ready status of the battery power VBAT;
FIG. 3C shows two consecutive symbol sections Symbol1 and Symbol2 for discussion of the connection of the regulation capacitors (including the transition capacitor Ctran and the voltage-regulated capacitors with the multi-level array 210);
FIGs 4A~4D show several embodiments of the multi-level array 210; and
FIGs 5A~5D show several embodiments of the assisted charging and discharging circuit 208.

### DETAILED DESCRIPTION OF THE INVENTION

The following description is made for the purpose of illustrating the general principles of the invention and should not be taken in a limiting sense. The scope of the invention is best determined by reference to the appended claims.

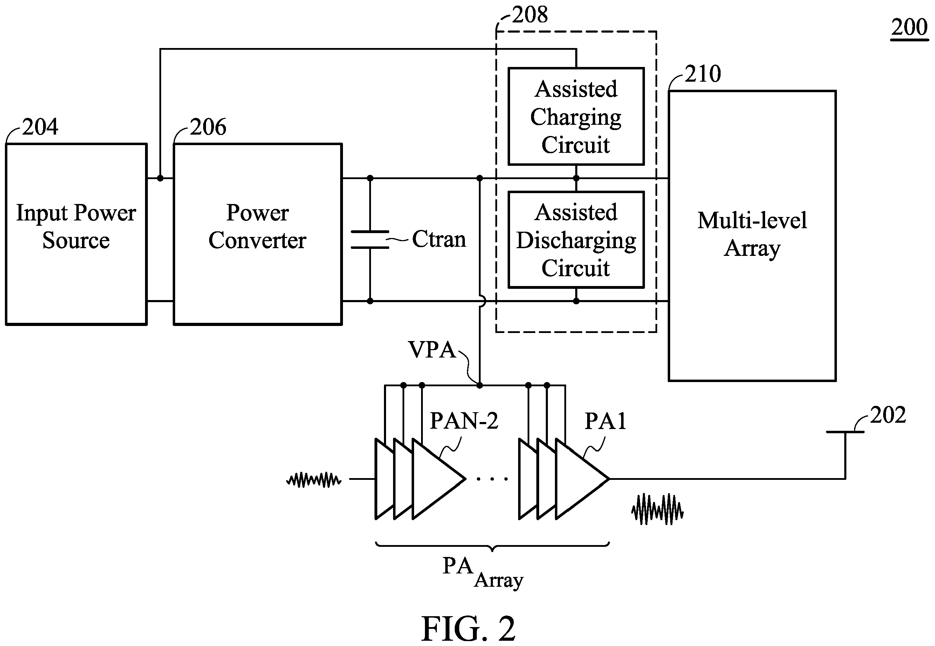

FIG. 2 illustrates a wireless device 200 in accordance with an exemplary embodiment of the preset invention. Radio frequency (RF) signals are amplified by an array of power amplifiers (PAs) to be transmitted by an antenna 202. A supply is shown in FIG. 2, which transforms the power of an input power source 204 (e.g., a battery) to a symbol-power-tracking (SPT) supply voltage VPA to power an RF PA PA_{Array}.

The SPT supply has a power converter 206, a transition capacitor Ctran, an assisted charging and discharging circuit 208, and a multi-level array 210. An output port of the input power source 204 is coupled to the power converter 206 for power conversion. The power converter 206 has an output terminal coupled to a power terminal of the RF PA PA_{Array}. The transition capacitor Ctran (coupled to the power terminal of the RF PA PA_{Array} through the output terminal of the power converter 206) and the multi-level array 210 including a plurality of voltage-regulated capacitors are provided for voltage regulation. An SPT supply voltage VPA is applied to the power terminal of the PA array. The power terminal of the RF PA PA_{Array} is charged/discharged by the assisted charging and discharging circuit 208 during cyclic prefix (CP) sections. In comparison with the transition capacitor Ctran, each voltage-regulated capacitor in the multi-level array 210 is more than an order of magnitude larger in size. The voltage-regulated capacitors in the multi-level array 210 are pre-charged to and kept at different voltage levels. Note that each voltage-regulated capacitor is kept at a fixed voltage level. During each symbol section, the voltage-regulated capacitor regulated at a fixed voltage level matching the current SPT situation is selected as a target capacitor to be coupled to the power terminal of the RF PA PA_{Array}. Rather than periodically charge/discharge a large capacitor, the SPT supply voltage VPA is easily changed to meet the current SPT situation by switching the connections between the voltage-regulated capacitors (provided in the multi-level array 210) and the power terminal of the RF PA PA_{Array}.

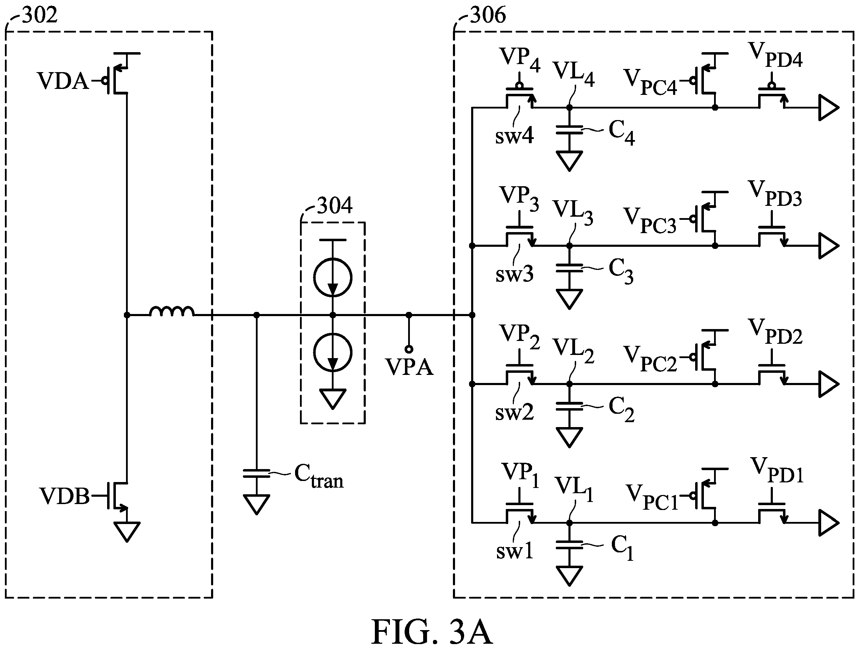

FIG. 3A depicts the details of a power converter 302, an assisted charging and discharging circuit 304, and a multi-level array 306 in accordance with an exemplary embodiment of the present invention. The power converter 302 is a dc-dc converter (a buck circuit). In the other exemplary embodiments, the buck circuit 302 may be replaced by a boost circuit or a buck-boost circuit. The multi-level array 306 includes voltage-regulated capacitors C1, C2, C3 and C4, a pre-charging design (controlled by signals VPC1~VPC4 and VPD1~VPD4) for the voltage-regulated capacitors C1~C4, and voltage regulation switches sw1~sw4 (corresponding to the voltage-regulated capacitors C1~C4 one to one). Each voltage regulation switch is coupled between its corresponding voltage-regulated capacitor and the power terminal of the RF PA PA_{Array} (to control the SPT supply voltage VPA). During a power-on period of a wireless device using the presented amplification system, the power converter 302 may be turned off (by controlling the signals VDA and VDB), and the assisted charging and discharging circuit 304 may be turned off, too. Referring to the multi-level array 306, during the power-on period, the voltage regulation switches sw1~sw4 are open (by controlling the signals VP1 to VP4), and the voltage-regulated capacitors C1~C4 are pre-charged to their expected fixed voltage levels by the pre-charging design (controlled by signals VPC1~VPC4 and VPD1~VPD4).

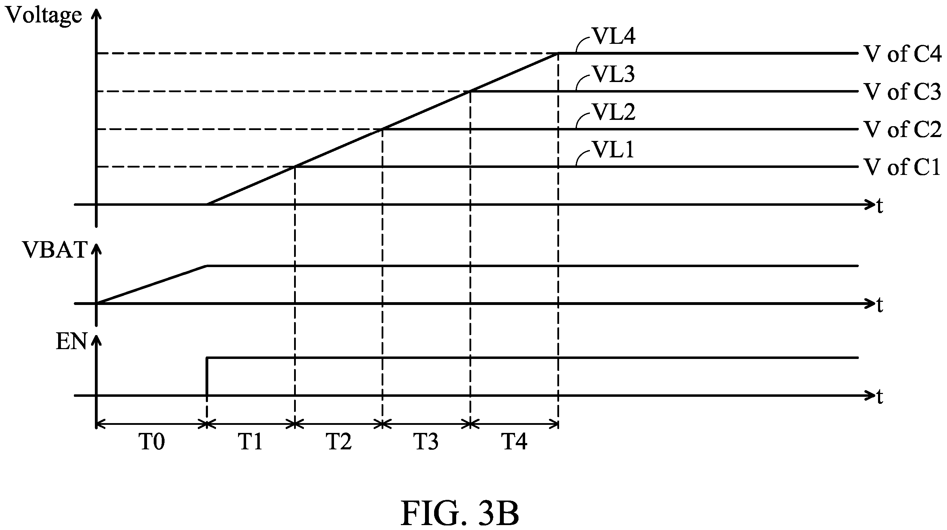

FIG. 3B depicts the waveforms of the voltage levels of the voltage-regulated capacitors C1~C4, the battery power VBAT, and the enable signal EN indicating the ready status of the battery power VBAT. During the power-on period, the waveforms changes step by step as shown in the timing intervals T0~T4. The battery power VBAT is gradually turned on in timing interval T0 and, when the battery power is ready, the enable signal EN is asserted. According to the asserted enable signal EN, the pre-charging of the voltage-regulated capacitors C1~C4 starts, and all of the control signals VPC1~VPC4 are low to establish charging paths for the voltage-regulated capacitors C1~C4. At the end of the timing interval T1, the voltage-regulated capacitor C1 reaches the first fixed voltage level VL1, and the control signal VPC1 changes high to break the charging path of the voltage-regulated capacitor C1. At the end of the timing interval T2, the voltage-regulated capacitor C2 reaches the second fixed voltage level VL2, and the control signal VPC2 changes high to break the charging path of the voltage-regulated capacitor C2. At the end of the timing interval T3, the voltage-regulated capacitor C3 reaches the third fixed voltage level VL3, and the control signal VPC3 changes high to break the charging path of the voltage-regulated capacitor C3. At the end of the timing interval T4, the voltage-regulated capacitor C4 reaches the fourth fixed voltage level VL4, and the control signal VPC4 changes high to break the charging path of the voltage-regulated capacitor C4. After the power-on period, the four fixed voltage levels VL1~VL4 have been stored in the voltage-regulated capacitors C1~C4, and the power converter 302 is turned-on to work the amplification system.

After the power-on period, the connection of the regulation capacitors (including the transition capacitor Ctran and the voltage-regulated capacitors C1~C4) are discussed in the following paragraphs.

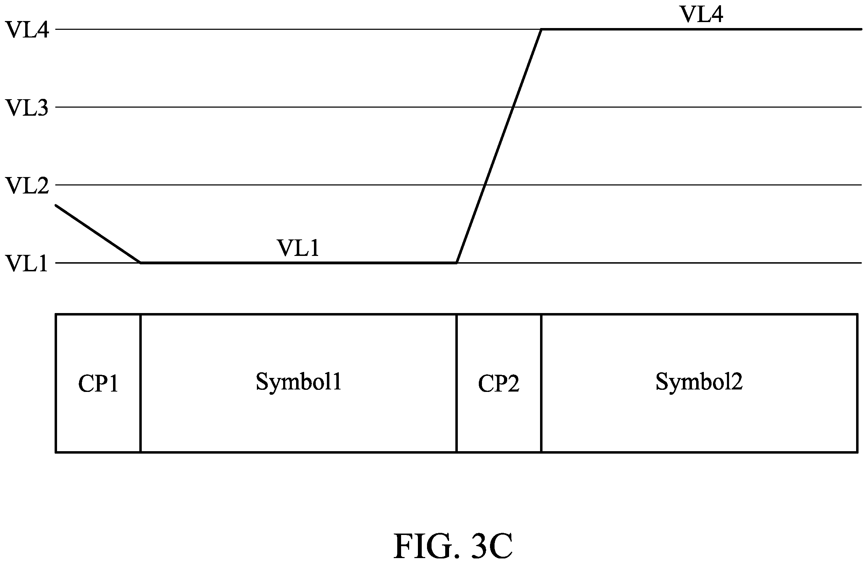

FIG. 3C shows two consecutive symbol sections Symbol1 and Symbol2. A first cyclic prefix (CP) section CP1 is required prior to the first symbol section Symbol1, and a second cyclic prefix (CP) section CP2 is required prior to the second symbol section Symbol2. In the first symbol section Symbol1, the SPT supply voltage VPA should be VL1. In the second symbol section Symbol2, the SPT supply voltage VPA should be VL4. In the first CP section CP1, the supply voltage VPA should transit from the previous level to the expected voltage level VL1. In the second CP section CP2, the supply voltage VPA should transit from VL1 to VL4.

In the first CP section CP1, all voltage regulation switches sw1~sw4 are open, and the transition capacitor Ctran is discharged by the assisted charging and discharging circuit 304 to the expected voltage level VL1. In the first symbol section Symbol1, the voltage regulation switch sw1 is closed, so that the voltage-regulated capacitor C1 (kept at the voltage level VL1) and the transition capacitor Ctran are connected in parallel between the power terminal of the RF PA PA_{Array} and the ground to provide a stable SPT supply voltage VL1 as VPA. Because the transition capacitor Ctran is much smaller than the voltage-regulated capacitor C1, it is OK to discharge the transition capacitor Ctran to the expected voltage level VL1 in the short CP section (e.g., 0.29µs for 5G applications). Furthermore, the large voltage-regulated capacitor C1 can provide strong regulation capability in the first symbol section Symbol1. In the second CP section CP2, all voltage regulation switches sw1~sw4 are open, and the transition capacitor Ctran is charged by the assisted charging and discharging circuit 304 from VL1 to VL4. In the following second symbol section Symbol2, the voltage regulation switch sw4 is closed, so that the voltage-regulated capacitor C4 (kept at the voltage level VL4) and the transition capacitor Ctran are connected in parallel between the power terminal of the RF PA PA_{Array} and the ground to provide a stable SPT supply voltage VL4 as VPA. Similarly, the small-sized transition capacitor Ctran is rapidly charged to the expected voltage level VL4 in the short CP section CP2. The large voltage-regulated capacitor C4 can provide strong regulation capability in the second symbol section Symbol2.

Furthermore, a current leakage solution for the voltage-regulated capacitors C1~C4 are introduced in the present invention. The different voltage-regulated capacitors relate to the different thresholds. When a voltage-regulated capacitor whose voltage level is dropped to lower than its corresponding threshold is disconnected from the power terminal of the RF PA PA_{Array}, the voltage-regulated capacitor can be charged to compensate for current leakage. For example, when the voltage-regulated capacitor C1 is connected in parallel with the transition capacitor Ctran in the first symbol section Symbol1, the control signals VPC2~VPC4 can be switched to low to establish charging paths for the other voltage-regulated capacitors C2~C4, and thereby the voltage-regulated capacitors C2~C4 are charged back to their fixed voltage levels VL2~VL4. Similarly, when the voltage-regulated capacitor C4 is connected in parallel with the transition capacitor Ctran in the second symbol section Symbol2, the control signals VPC1~VPC3 can be switched to low to establish charging paths for the other voltage-regulated capacitors C1~C3, and thereby the voltage-regulated capacitors C1~C3 are charged back to their fixed voltage levels VL1~VL3. There may be a detection circuit that detects the current leakage of the voltage-regulated capacitors C1~C4.

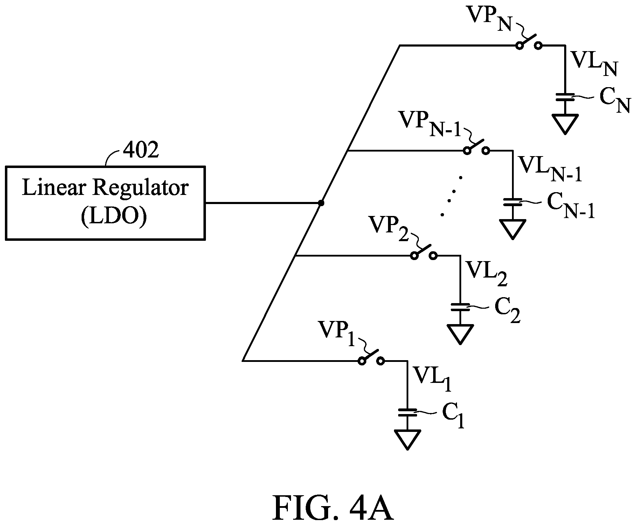

FIGs 4A~4D show several embodiments of the multi-level array 210. The multi-level array comprises a plurality of charging switches (controlled by signals VP1~VPN) that correspond one-to-one with the voltage-regulated capacitors C1~CN. Each charging switch is closed to establish a pre-charging path for one voltage-regulated capacitor until the voltage-regulated capacitor is pre-charged to its expected fixed voltage level. When a voltage-regulated capacitor whose voltage level is dropped to lower than its corresponding threshold is disconnected from the power terminal of the RF PA PA_{Array}, the corresponding charging switch is closed again until the voltage-regulated capacitor is charged back to its expected fixed fixed voltage level.

In FIG. 4A, the multi-level array comprises one single linear regulator 402, which is coupled to the voltage-regulated capacitors C1~CN through the charging switches for capacitor charging.

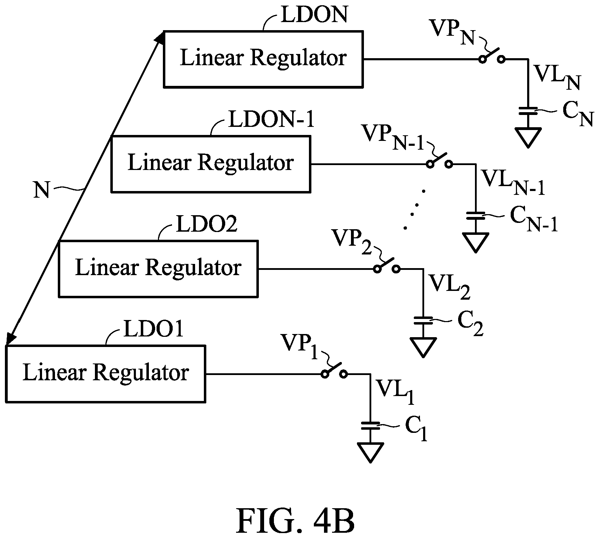

In FIG. 4B, the multi-level array comprises a plurality of linear regulators LDO1~ LDON that correspond one-to-one with the voltage-regulated capacitors C1~CN. Each linear regulator is coupled to one voltage-regulated capacitor through one charging switch to charge the corresponding voltage-regulated capacitor.

Because pre-charging of the voltage-regulated capacitors C1~CN is planned in the power-on period, there is sufficient time for the slow LDO to pre-charge the voltage-regulated capacitors C1~CN to the fixed voltage levels VL1~VLN. The circuit cost can be reduced. However, it is not limited to using LDO technique for pre-charging the voltage-regulated capacitors C1~CN.

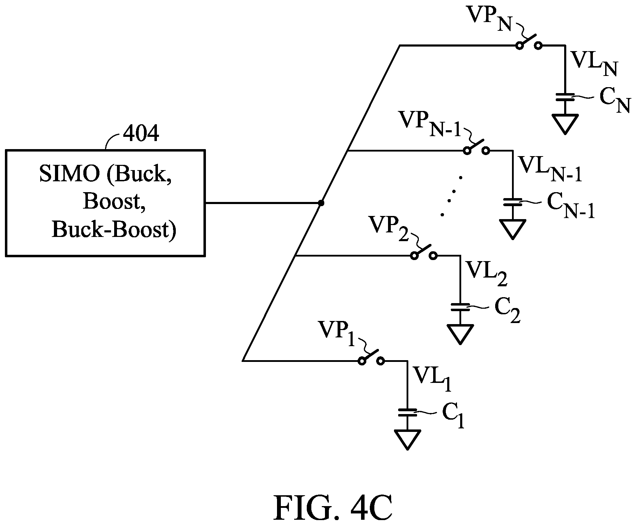

In FIG. 4C, the multi-level array comprises a single-input and multiple-output (SIMO) dc-dc converter (a buck, a boost, or a buck-boost circuit) 404, to be coupled to the voltage-regulated capacitors C1~CN through the charging switches for capacitor charging.

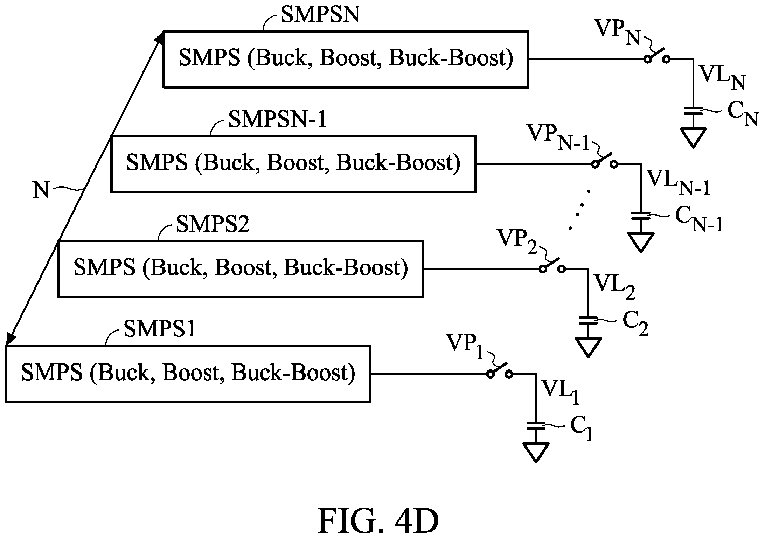

In FIG. 4D, the multi-level array comprises a plurality of switched-mode power supplies (SMPS, e.g., a buck, a boost, or a buck-boost circuit) SMPS1~SMPSN corresponding to the voltage-regulated capacitors C1~CN one to one. Each switched-mode power supply (SMPS) is coupled to its corresponding voltage-regulated capacitor, through the corresponding charging switch, for capacitor charging.

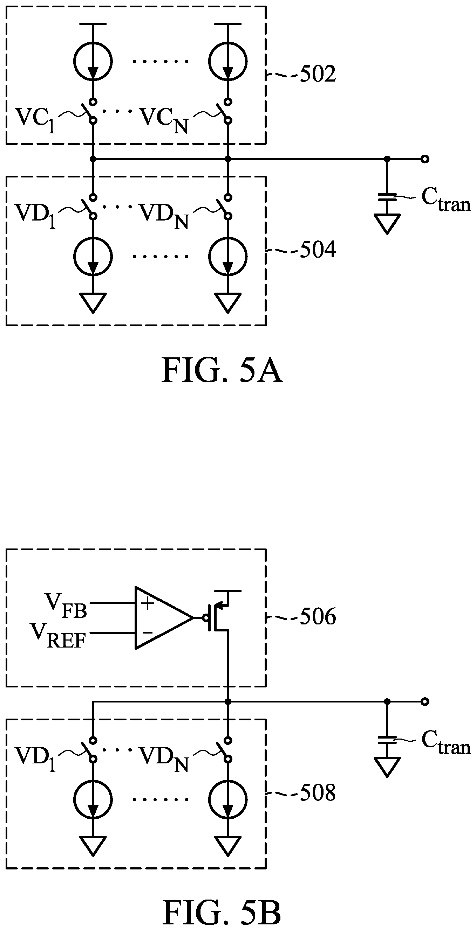

FIGs 5A~5D show several embodiments of the assisted charging and discharging circuit 208.

In FIG. 5A, the assisted charging and discharging circuit comprises two sets of current sources 502 and 504. The first set of current sources 502 includes current sources which are turned on in several manners (by switching the control signals VC1~VCN) to provide different charging currents for the transition capacitor Ctran. The second set of current sources 504 includes current sources which are turned on in several manners (by switching the control signals VD1~VDN) to provide different discharging currents for the transition capacitor Ctran.

In FIG. 5B, the assisted charging and discharging circuit comprises a linear regulator 506 and one set of current sources 508. The linear regulator 506 is operated (according to a feedback voltage VFB and a reference voltage VREF) to charge the transition capacitor Ctran. The set of current sources 508 includes current sources which are turned on in several manners (by switching the control signals VD1~VDN) to provide different discharging currents for the transition capacitor Ctran.

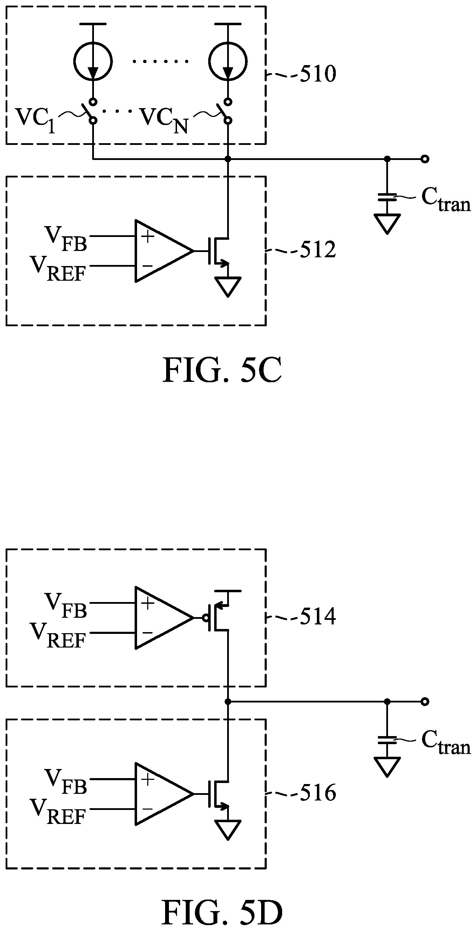

In FIG. 5C, the assisted charging and discharging circuit comprises one set of current sources 510 and a linear regulator 512. The set of current sources 510 includes current sources which are turned on in several manners (by switching the control signals VC1~VCN) to provide different charging currents for the transition capacitor Ctran. The linear regulator 512 is operated to discharge the transition capacitor Ctran.

In FIG. 5D, the assisted charging and discharging circuit comprises two linear regulators 514 and 516. The linear regulator 514 is operated to charge the transition capacitor Ctran. The linear regulator 516 is operated to discharge the transition capacitor Ctran.

Any amplification system for a wireless device uses the multi-level array 210 should be considered within the scope of the present invention.

In some exemplary embodiments, the forgoing SPT supply may be applied to power other electronic elements rather than a power amplifier. In some exemplary embodiments, the timing to charge/discharge the transition capacitor Ctran is not limited to cyclic prefix sections, and the timing to connect a target capacitor (selected from the voltage-regulated capacitors within the multi-level array) and the transition capacitor Ctran in parallel is not limited to the symbol sections. There may be some timing shift considering the circuit delays.

## Claims

1. A symbol-power-tracking supply, comprising:
a power converter (206), coupled to an output port of an input power source (204) for power conversion, and having an output terminal coupled to a power terminal of an electronic element;
a transition capacitor (Ctran), coupled to the power terminal of the electronic element through the output terminal of the power converter;
an assisted charging and discharging circuit (208), coupled to the transition capacitor; and
a multi-level array (210, 306), including a plurality of voltage-regulated capacitors (C1-C4) which are pre-charged to different fixed voltage levels during a power-on period and kept at the fixed voltage levels, wherein, a target capacitor is selected from among the plurality of voltage-regulated capacitors to be coupled to the power terminal;
wherein:
the assisted charging and discharging circuit charges or discharges the transition capacitor to a symbol-power-tracking level during a cyclic prefix section; and
during a symbol section following the cyclic prefix section, a voltage-regulated capacitor kept at a fixed voltage level which is the same as the symbol power-tracking level is selected as the target capacitor to be coupled to the power terminal of the electronic element.

2. The symbol-power-tracking supply as claimed in claim 1, wherein:
the multi-level array further comprises charging switches that correspond one-to-one with the voltage-regulated capacitors;
each charging switch is closed to establish a pre-charging path for the corresponding voltage-regulated capacitor until the corresponding voltage-regulated capacitor is pre-charged to its expected fixed voltage level.

3. The symbol-power-tracking supply as claimed in claim 2, wherein:
the different voltage-regulated capacitors correspond to different thresholds; and
when a voltage-regulated capacitor whose voltage level decreases to lower than its corresponding threshold is disconnected from the power terminal of the electronic element, the corresponding charging switch is closed again until the voltage-regulated capacitor is charged back to its expected fixed voltage level.

4. The symbol-power-tracking supply as claimed in claim 3, wherein:
the multi-level array further comprises one single linear regulator, to be coupled to the voltage-regulated capacitors through the charging switches for capacitor charging.

5. The symbol-power-tracking supply as claimed in claim 3, wherein:
the multi-level array further comprises linear regulators that correspond one-to-one with the voltage-regulated capacitors; and
each linear regulator is coupled to the corresponding voltage-regulated capacitor, through the corresponding charging switch, for capacitor charging.

6. The symbol-power-tracking supply as claimed in claim 3, wherein:
the multi-level array further comprises a single-input and multiple-output dc-dc converter, to be coupled to the voltage-regulated capacitors through the charging switches for capacitor charging.

7. The symbol-power-tracking supply as claimed in claim 3, wherein:
the multi-level array further comprises switched-mode power supplies that correspond one-to-one with the voltage-regulated capacitors; and
each switched-mode power supply is coupled to the corresponding voltage-regulated capacitor, through the corresponding charging switch, for capacitor charging.

8. The symbol-power-tracking supply as claimed in any one of the preceding claims, wherein the assisted charging and discharging circuit comprises:
a first set of current sources, including current sources which are turned on in several manners to provide different charging currents for the transition capacitor; and
a second set of current sources, including current sources which are turned on in several manners to provide different discharging currents for the transition capacitor.

9. The symbol-power-tracking supply as claimed in any one of claims 1 to 7, wherein the assisted charging and discharging circuit comprises:
a linear regulator for charging the transition capacitor; and
a set of current sources, including current sources which are turned on in several manners to provide different discharging currents for the transition capacitor.

10. The symbol-power-tracking supply as claimed in any one of claims 1 to 7, wherein the assisted charging and discharging circuit comprises:
a set of current sources, including current sources which are turned on in several manners to provide different charging currents for the transition capacitor; and
a linear regulator for discharging the transition capacitor.

11. The symbol-power-tracking supply as claimed in any one of claims 1 to 7, wherein the assisted charging and discharging circuit comprises:
a first linear regulator for charging the transition capacitor; and
a second linear regulator for discharging the transition capacitor.

12. The symbol-power-tracking supply as claimed in any one of the preceding claims, wherein:
the power converter is a dc-dc converter.

13. The symbol-power-tracking supply as claimed in any of the preceding claims, wherein:
the multi-level array further comprises voltage regulation switches that correspond one-to-one with the voltage-regulated capacitors, and each voltage regulation switch is coupled between the corresponding voltage-regulated capacitor and the power terminal of the electronic element.

14. A wireless device, comprising:
a symbol-power-tracking supply as claimed in any of claims 1 to 13;
a radio-frequency power amplifier that is the electronic element powered by the symbol-power-tracking supply; and
an antenna, transmitting radio signals provided by the radio-frequency power amplifier.

## Patentansprüche

1. Symbol-Leistungsverfolgungsversorgung, umfassend:
einen Leistungswandler (206), der zur Leistungswandlung mit einem Ausgabeport einer Eingabeleistungsquelle (204) gekoppelt ist, und ein mit einem Leistungsterminal eines elektronischen Elements gekoppeltes Ausgabeterminal aufweist;
einen Übergangskondensator (Ctran), der über das Ausgabeterminal des Leistungswandlers mit dem Leistungsterminal des elektronischen Elements gekoppelt ist;
eine unterstützte Lade- und Entladeschaltung (208), die mit dem Übergangskondensator gekoppelt ist; und
ein Multi-Pegel-Array (210, 306), das eine Vielzahl von spannungsgeregelten Kondensatoren (C1-C4) einschließt, die während einer Einschaltperiode auf verschiedene fixierte Spannungspegel vorgeladen und auf den fixierten Spannungspegeln gehalten werden, wobei ein Zielkondensator aus der Vielzahl von spannungsgeregelten Kondensatoren ausgewählt wird, um mit dem Leistungsterminal gekoppelt zu werden;
wobei:
die unterstützte Lade- und Entladeschaltung den Übergangskondensator während einer zyklischen Präfix-Sektion auf einen Symbol-Leistungsverfolgungspegel lädt oder entlädt; und
während einer auf die zyklische Präfix-Sektion folgenden Symbol-Sektion ein spannungsgeregelter Kondensator, der auf einem fixierten Spannungspegel gehalten wird, der derselbe wie der Symbol-Leistungsverfolgungspegel ist, als der Zielkondensator ausgewählt wird, der mit dem Leistungsterminal des elektronischen Elements gekoppelt werden soll.

2. Symbol-Leistungsverfolgungsversorgung nach Anspruch 1, wobei:
das Multi-Pegel-Array weiter Ladeschalter umfasst, die eins zu eins den spannungsgeregelten Kondensatoren entsprechen;
jeder Ladeschalter geschlossen wird, um einen Vorlade-Pfad des entsprechenden spannungsgeregelten Kondensators herzustellen, bis der entsprechende spannungsgeregelte Kondensator auf seinen erwarteten fixierten Spannungspegel vorgeladen ist.

3. Symbol-Leistungsverfolgungsversorgung nach Anspruch 2, wobei:
die verschiedenen spannungsgeregelten Kondensatoren verschiedenen Schwellenwerten entsprechen; und
wenn ein spannungsgeregelter Kondensator, dessen Spannungspegel unter seinen entsprechenden Schwellenwert abnimmt, von dem Leistungsterminal des elektronischen Elements getrennt wird, der entsprechende Ladeschalter wieder geschlossen wird, bis der spannungsgeregelte Kondensator wieder auf seinen erwarteten fixierten Spannungspegel geladen ist.

4. Symbol-Leistungsverfolgungsversorgung nach Anspruch 3, wobei:
das Multi-Pegel-Array weiter einen einzigen linearen Regler umfasst, der über die Ladeschalter zum Kondensatorladen mit den spannungsgeregelten Kondensatoren gekoppelt werden soll.

5. Symbol-Leistungsverfolgungsversorgung nach Anspruch 3, wobei:
das Multi-Pegel-Array weiter lineare Regler umfasst, die eins zu eins den spannungsgeregelten Kondensatoren entsprechen; und
jeder lineare Regler über den entsprechenden Ladeschalter mit dem entsprechenden spannungsgeregelten Kondensator gekoppelt ist, zum Kondensatorladen.

6. Symbol-Leistungsverfolgungsversorgung nach Anspruch 3, wobei:
das Multi-Pegel-Array weiter einen Einzel-Eingabe- und Mehrfach-Ausgabe-DC-DC-Wandler umfasst, der über die Ladeschalter zum Kondensatorladen mit den spannungsgeregelten Kondensatoren gekoppelt werden soll.

7. Symbol-Leistungsverfolgungsversorgung nach Anspruch 3, wobei:
das Multi-Pegel-Array weiter Umschaltmodus-Leistungsversorgungen umfasst, die eins zu eins den spannungsgeregelten Kondensatoren entsprechen; und jede Umschaltmodus-Leistungsversorgung über den entsprechenden Ladeschalter mit dem entsprechenden spannungsgeregelten Kondensator gekoppelt ist, zum Kondensatorladen.

8. Symbol-Leistungsverfolgungsversorgung nach einem der vorstehenden Ansprüche, wobei die unterstützte Lade- und Entladeschaltung folgendes umfasst:
einen ersten Satz von Stromquellen, die Stromquellen einschließen, die auf verschiedene Arten eingeschaltet werden, um unterschiedliche Ladeströme für den Übergangskondensator bereitzustellen; und
einen zweiten Satz von Stromquellen, die Stromquellen einschließen, die auf verschiedene Arten eingeschaltet werden, um unterschiedliche Entladeströme für den Übergangskondensator bereitzustellen.

9. Symbol-Leistungsverfolgungsversorgung nach einem der Ansprüche 1 bis 7, wobei die unterstützte Lade- und Entladeschaltung folgendes umfasst:
einen linearen Regler zum Laden des Übergangskondensators; und
einen Satz von Stromquellen, die Stromquellen einschließen, die auf verschiedene Arten eingeschaltet werden, um unterschiedliche Entladeströme für den Übergangskondensator bereitzustellen.

10. Symbol-Leistungsverfolgungsversorgung nach einem der Ansprüche 1 bis 7, wobei die unterstützte Lade- und Entladeschaltung folgendes umfasst:
einen Satz von Stromquellen, die Stromquellen einschließen, die auf verschiedene Arten eingeschaltet werden, um unterschiedliche Ladeströme für den Übergangskondensator bereitzustellen; und
einen linearen Regler zum Entladen des Übergangskondensators.

11. Symbol-Leistungsverfolgungsversorgung nach einem der Ansprüche 1 bis 7, wobei die unterstützte Lade- und Entladeschaltung folgendes umfasst:
einen ersten linearen Regler zum Laden des Übergangskondensators; und
einen zweiten linearen Regler zum Entladen des Übergangskondensators.

12. Symbol-Leistungsverfolgungsversorgung nach einem der vorstehenden Ansprüche, wobei:
der Leistungswandler ein DC-DC-Wandler ist.

13. Symbol-Leistungsverfolgungsversorgung nach einem der vorstehenden Ansprüche, wobei:
das Multi-Pegel-Array weiter Spannungsregelungsschalter umfasst, die eins zu eins den spannungsgeregelten Kondensatoren entsprechen, und jeder Spannungsregelungsschalter zwischen dem entsprechenden spannungsgeregelten Kondensator und dem Leistungsterminal des elektronischen Elements gekoppelt ist.

14. Drahtlose Vorrichtung, umfassend:
Symbol-Leistungsverfolgungsversorgung, wie in einem der Ansprüche 1 bis 13 beansprucht;
einen Hochfrequenz-Leistungsverstärker, der das elektronische Element ist, das von der Symbol-Leistungsverfolgungsversorgung mit Leistung versorgt wird; und
eine Antenne, die Funksignale überträgt, die von dem Hochfrequenz-Leistungsverstärker bereitgestellt werden.

## Revendications

1. Alimentation de suivi de puissance de symboles, comprenant :
un convertisseur de puissance (206), couplé à un port de sortie d'une source de puissance d'entrée (204) pour une conversion de puissance, et présentant une borne de sortie couplée à une borne de puissance d'un élément électronique ;
un condensateur de transition (Ctran), couplé à la borne de puissance de l'élément électronique à travers la borne de sortie du convertisseur de puissance ;
un circuit de charge et de décharge assistées (208), couplé au condensateur de transition ; et
un ensemble multi-niveaux (210, 306), incluant une pluralité de condensateurs régulés par la tension (C1-C4) qui sont pré-chargés à différents niveaux de tension fixes durant une période de mise sous tension et maintenus aux niveaux de tension fixes, dans lequel, un condensateur cible est sélectionné parmi la pluralité de condensateurs régulés par la tension destinés à être couplés à la borne de puissance ;
dans laquelle :
le circuit de charge et de décharge assistées charge ou décharge le condensateur de transition à un niveau de suivi de puissance de symboles durant une section de préfixes cycliques ; et
durant une section de symboles suivant la section de préfixes cycliques, un condensateur régulé par la tension maintenu à un niveau de tension fixe qui est le même que le niveau de suivi de puissance de symboles est sélectionné en tant que condensateur cible destiné à être couplé à la borne de puissance de l'élément électronique.

2. Alimentation de suivi de puissance de symboles telle que revendiquée dans la revendication 1, dans laquelle :
l'ensemble multi-niveaux comprend en outre des commutateurs de charge qui correspondent un à un aux condensateurs régulés par la tension ;
chaque commutateur de charge est fermé pour établir un chemin de pré-charge pour le condensateur régulé par la tension correspondant jusqu'à ce que le condensateur régulé par la tension correspondant soit pré-chargé à son niveau de tension fixe attendu.

3. Alimentation de suivi de puissance de symboles telle que revendiquée dans la revendication 2, dans laquelle :
les différents condensateurs régulés par la tension correspondent à différents seuils ; et
lorsqu'un condensateur régulé par la tension dont le niveau de tension diminue en-dessous de son seuil correspondant est déconnecté de la borne de puissance de l'élément électronique, le commutateur de charge correspondant est à nouveau fermé jusqu'à ce que le condensateur régulé par la tension soit rechargé à son niveau de tension fixe attendu.

4. Alimentation de suivi de puissance de symboles telle que revendiquée dans la revendication 3, dans laquelle :
l'ensemble multi-niveaux comprend en outre un unique régulateur linéaire, destiné à être couplé aux condensateurs régulés par la tension à travers les commutateurs de charge pour la charge des condensateurs.

5. Alimentation de suivi de puissance de symboles telle que revendiquée dans la revendication 3, dans laquelle :
l'ensemble multi-niveaux comprend en outre des régulateurs linéaires qui correspondent un à un aux condensateurs régulés par la tension ; et
chaque régulateur linéaire est couplé au condensateur régulé par la tension correspondant, à travers le commutateur de charge correspondant, pour la charge des condensateurs.

6. Alimentation de suivi de puissance de symboles telle que revendiquée dans la revendication 3, dans laquelle :
l'ensemble multi-niveaux comprend en outre un convertisseur de courant continu en courant continu dc-dc à entrée unique et sorties multiples, destiné à être couplé aux condensateurs régulés par la tension à travers les commutateurs de charge pour la charge des condensateurs.

7. Alimentation de suivi de puissance de symboles telle que revendiquée dans la revendication 3, dans laquelle :
l'ensemble multi-niveaux comprend en outre des alimentations en puissance à mode commuté qui correspondent une à une aux condensateurs régulés par la tension ; et chaque alimentation en puissance à mode commuté est couplée au condensateur régulé par la tension correspondant, à travers le commutateur de charge correspondant, pour la charge des condensateurs.

8. Alimentation de suivi de puissance de symboles telle que revendiquée dans l'une quelconque des revendications précédentes, dans laquelle le circuit de charge et de décharge assistées comprend :
un premier ensemble de sources de courant, incluant des sources de courant qui sont mises en marche de plusieurs manières pour fournir différents courants de charge pour le condensateur de transition ; et
un second ensemble de sources de courant, incluant des sources de courant qui sont mises en marche de plusieurs manières pour fournir différents courants de décharge pour le condensateur de transition.

9. Alimentation de suivi de puissance de symboles telle que revendiquée dans l'une quelconque des revendications 1 à 7, dans laquelle le circuit de charge et de décharge assistées comprend :
un régulateur linéaire pour charger le condensateur de transition ; et
un ensemble de sources de courant, incluant des sources de courant qui sont mises en marche de plusieurs manières pour fournir différents courants de décharge pour le condensateur de transition.

10. Alimentation de suivi de puissance de symboles telle que revendiquée dans l'une quelconque des revendications 1 à 7, dans laquelle le circuit de charge et de décharge assistées comprend :
un ensemble de sources de courant, incluant des sources de courant qui sont mises en marche de plusieurs manières pour fournir différents courants de charge pour le condensateur de transition ; et
un régulateur linéaire pour décharger le condensateur de transition.

11. Alimentation de suivi de puissance de symboles telle que revendiquée dans l'une quelconque des revendications 1 à 7, dans laquelle le circuit de charge et de décharge assistées comprend :
un premier régulateur linéaire pour charger le condensateur de transition ; et
un second régulateur linéaire pour décharger le condensateur de transition.

12. Alimentation de suivi de puissance de symboles telle que revendiquée dans l'une quelconque des revendications précédentes, dans laquelle :
le convertisseur de puissance est un convertisseur de courant continu en courant continu dc-dc.

13. Alimentation de suivi de puissance de symboles telle que revendiquée dans l'une quelconque des revendications précédentes, dans laquelle :
l'ensemble multi-niveaux comprend en outre des commutateurs de régulation de tension qui correspondent un à un aux condensateurs régulés par la tension, et chaque commutateur de régulation de tension est couplé entre le condensateur régulé par la tension correspondant et la borne de puissance de l'élément électronique.

14. Dispositif sans fil, comprenant :
une alimentation de suivi de puissance de symboles telle que revendiquée dans l'une quelconque des revendications 1 à 13 ;
un amplificateur de puissance radiofréquence qui est l'élément électronique alimenté par l'alimentation de suivi de puissance de symboles ; et
une antenne, transmettant des signaux radio fournis par l'amplificateur de puissance radiofréquence.
